# EUROPEAN PATENT APPLICATION

(11) **EP 4 836 288 A1**
(43) Date of publication of application: **04.11.2026**
(21) Application number: 24913726.6
(22) Date of filing: 27.12.2024
(51) Int. Cl.: H02P 29/02, H02P 29/60, H02P 7/29, H02P 7/292, G01R 31/34, H05K 7/20

(54) **POWER CONVERSION DEVICE**

(30) Priority: 28.12.2023 KR 20230195590
(71) Applicant: LG Innotek Co., Ltd., Seoul 07796 (KR)
(72) Inventor: KWON, Gook Min, Seoul 07796 (KR); LEE, Jeong Heum, Seoul 07796 (KR); LEE, Kyu Min, Seoul 07796 (KR)
(74) Representative: DREISS Patentanwälte PartG mbB
(86) International application number: PCT/KR2024/021359
(87) International publication number: WO 2025/143922

(57) **Abstract**

The present invention relates to a power conversion device capable of efficiently controlling a fan module, the power conversion device comprising: a housing which accommodates a plurality of elements for performing power conversion; a plurality of fans mounted on the housing; a plurality of temperature measurement elements for measuring the temperatures of a plurality of temperature measurement points inside the housing, each corresponding to the mounting positions of the plurality of fans; a power supply unit for supplying individual power to the plurality of fans; and a control unit for performing PWM control of the plurality of fans.

## Description

### [Technical Field]

resent disclosure relates to a power conversion device, and more specifically, to a power conversion device capable of efficient fan module control.

### [Background Art]

Fast chargers for electric vehicles (EVs) configure power modules with capacities of tens of kW in parallel to support high-speed charging of several hundred kW, thereby outputting a large amount of power. When connected to the EV, the power module receives AC power from a grid and outputs DC power to charge the EV's battery.

Significant heat is generated during power conversion within the power module. Since the power conversion efficiency of the power module is heavily affected by heat, heat dissipation is critical. Air cooling, which lowers heat through airflow, is used for heat dissipation; therefore, there is a need to develop technology for efficiently executing heat dissipation using this air cooling method.

### [Disclosure]

### [Technical Problem]

An object of the present disclosure is to provide a power conversion device capable of efficient fan module control.

### [Technical Solution]

To solve the above technical problem, a power conversion device according to one embodiment of the present disclosure includes a housing configured to accommodate a plurality of elements that perform power conversion; a plurality of fans mounted in the housing; a plurality of temperature measuring elements configured to respectively measure the temperature of a plurality of temperature measuring points inside the housing corresponding to the mounting positions of the plurality of fans, respectively; a power supply part configured to supply individual power to the plurality of fans; and a controller configured to perform PWM control of the plurality of fans.

In addition, the controller individually may control the plurality of fans using the temperature of each of the plurality of temperature measurement points measured by the plurality of temperature measuring elements and the difference between each temperature.

In addition, the controller may apply a PWM signal having the same duty to the plurality of fans when the difference between each temperature of the plurality of temperature measurement points is a first value or less.

In addition, the controller, when the difference between each temperature of the plurality of temperature measurement points is greater than a first value, may apply a PWM signal having a higher duty cycle than other fans to a fan corresponding to the temperature measurement point with the highest temperature among the plurality of temperature measurement points.

In addition, the controller may apply a PWM signal having a maximum duty cycle to a fan corresponding to the temperature measurement point with the highest temperature among the plurality of temperature measurement points.

In addition, the power conversion device further includes a fault detection part configured to detect a fault in the plurality of fans, in which the controller may control the plurality of fans according to a signal from the fault detection part.

In addition, the controller may stop the operation of a fan among the plurality of fans that has received a fault signal from the fault detection part, and operate a fan among the plurality of fans that has not received a fault signal from the fault detection part according to the temperature measured by the plurality of temperature measuring devices.

In addition, the power supply part may include a plurality of power conversion parts each connected to the plurality of fans to supply the individual power, and a monitoring part configured to monitor information of the plurality of power conversion parts.

In addition, the power conversion device further includes an auxiliary power supply part configured to supply power to the controller, in which the power supply part may convert power applied from the auxiliary power supply part and supply the power to each of the plurality of fans.

In addition, the plurality of temperature measuring elements may include an NTC element or a PTC element.

### [Advantageous Effect]

According to an embodiment of the present disclosure, the performance of the power module can be improved.

### [Description of Drawings]

FIG. 1 illustrates a power conversion device according to an embodiment of the present disclosure.
FIGS. 2 to 4 are block diagrams illustrating a power conversion device according to an embodiment of the present disclosure.
FIGS. 5 to 7 are drawings for explaining a power conversion device according to an embodiment of the present disclosure.

### [Best Mode]

Hereinafter, preferred embodiments of the present disclosure will be described in detail with reference to the attached drawings.

However, the technical idea of the present disclosure is not limited to some of the embodiments described, but can be implemented in various different forms, and within the scope of the technical idea of the present disclosure, one or more of the components between the embodiments can be selectively combined or substituted and used.

In addition, terms (including technical and scientific terms) used in an embodiment of the present disclosure can be interpreted as meanings that can be generally understood by a person having ordinary knowledge in the technical field to which the present disclosure belongs, unless explicitly and specifically defined and described, and terms that are commonly used, such as terms defined in a dictionary, can be interpreted in consideration of the contextual meaning of the related technology.

In addition, terms used in the embodiment of the present disclosure are used to describe the embodiments and are not intended to limit the present disclosure.

In this specification, the singular may also include the plural unless specifically stated otherwise in the phrase, and when it is described as "at least one (or one or more) of A, B, C", it may include one or more of all combinations that can be combined with A, B, C.

In addition, in describing components of the present embodiment of the present disclosure, terms such as first, second, A, B, (a), (b), or the like may be used. These terms are only intended to distinguish the components from other components, and are not intended to limit the nature, order, or sequence of the components.

In addition, when a component is described as being 'connected', 'coupled', or 'accessed' to another component, it may include not only cases where the component is 'connected', 'coupled', or 'accessed' directly to the other component, but also cases where the component is 'connected', 'coupled', or 'accessed' by another component between the component and the other component.

In addition, when described as being formed or disposed "above" or "below" each component, "above" or "below" includes not only the case where the two components are in direct contact with each other, but also the case where one or more other components are formed or disposed between the two components. In addition, when expressed as "above" or "below", the meaning of the downward direction as well as the upward direction based on one component may be included.

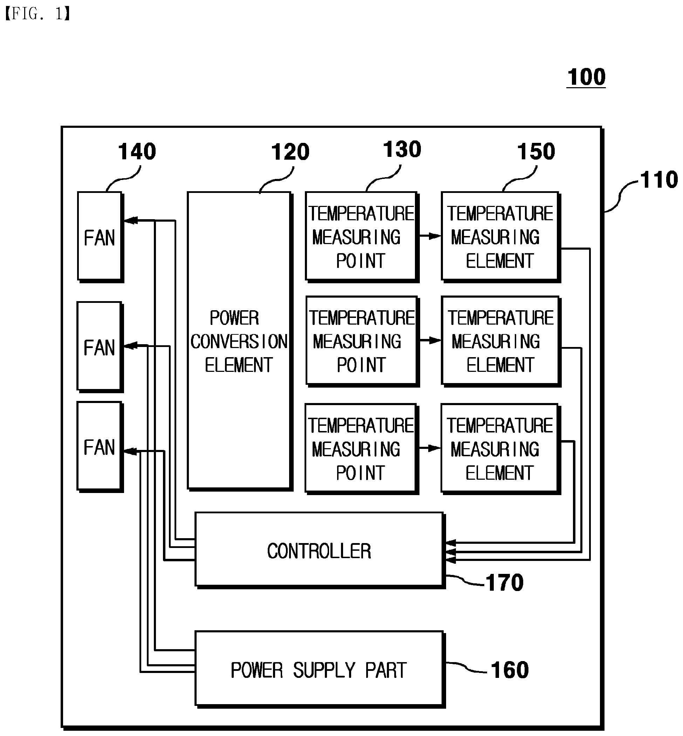

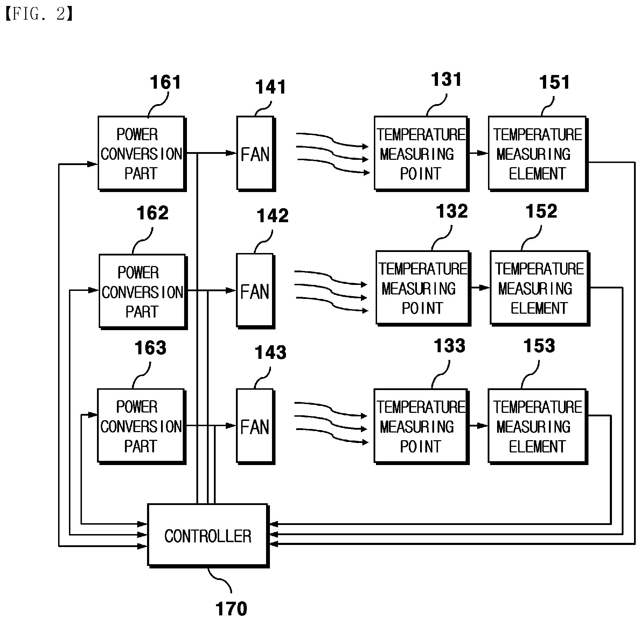

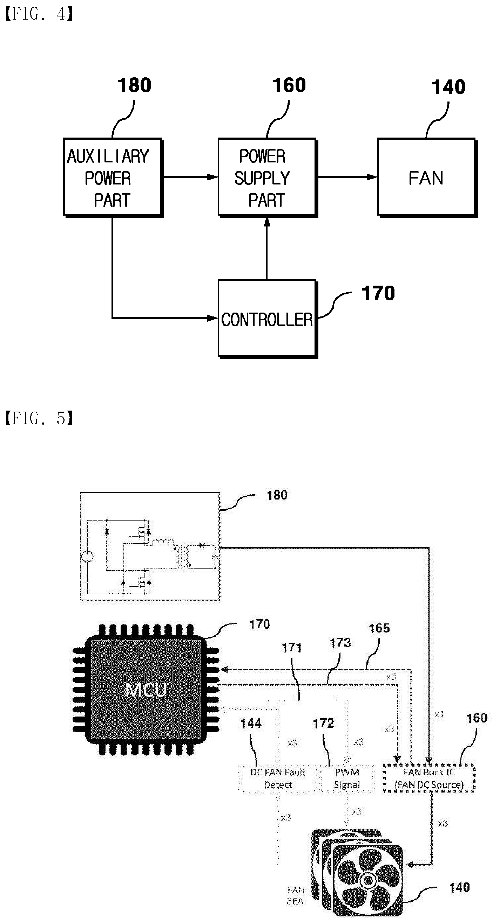

FIG. 1 illustrates a power conversion device according to an embodiment of the present disclosure, FIGS. 2 to 4 are block diagrams illustrating a power conversion device according to an embodiment of the present disclosure, and FIGS. 5 to 7 are drawings for explaining a power conversion device according to an embodiment of the present disclosure.

A power conversion device 100 according to an embodiment of the present disclosure is composed of a housing 110, a power conversion element 120, a fan 140, a temperature measuring element 150, a power supply part 160, and a controller 170, and may include a fault detection part 144, a monitoring part 164, and a power conversion part 161.

The power conversion device 100 according to an embodiment of the present disclosure may be a power conversion device for an electric vehicle charging device. Here, the power conversion device 100 may be a power module of an electric vehicle charging device. The power module may receive AC power from a grid (50/60Hz), convert the AC power into DC power for charging an electric vehicle battery, and output the DC power. Alternatively, the power module may receive DC power from an energy storage system ESS, convert the DC power into DC power for charging a battery, and output the DC power. The power module may receive power from an external power source, such as a solar power generation module. The power module may include an AC-DC rectifier and a DC-DC converter, and the power conversion device 100 according to an embodiment of the present disclosure may include an isolated DC-DC converter or a non-isolated converter. Among the isolated DC-DC converters, it may include a PSFB (Phase Shift Full Bridge) converter, a resonant LLC converter, a CLLC resonant converter, and a DAB (Dual Active Bridge) converter. Among the non-isolated DC-DC converters, it may include a buck converter, a boost converter, and a buck-boost converter.

The power conversion element 120 and other elements or components included in the power conversion device 100 are disposed within an accommodation space inside a housing 110. The housing 110 may include a housing that forms an internal space and a cover that covers the housing.

The power conversion element 120 can convert and output power input to the power conversion device 100. The power conversion element 120 may include an AC-DC rectifier, a DC-DC converter, or an AC-DC inverter. The power conversion element 120 may include one or more switching elements, and the switching elements may be semiconductor elements such as MOSFETs, and since semiconductor devices generate a lot of heat during switching operations and their switching efficiency is greatly affected by temperature, heat dissipation is important.

A fan 140 is formed on at least one surface of the housing 110 to introduce air into the housing 110 or to discharge air from the housing 110 to the outside. The fan creates an airflow inside the housing 110 and can serve to lower the heat generated by heat-generating elements, such as switching elements included in the power conversion element, or the like, disposed inside the housing 110. The fan 140 may be a DC fan that operates on DC power, and the fan 140 may include a plurality of fans. The fan 140 may include two or more, or three fans. The plurality of fans 141, 142, 143 may be disposed in a row on one side plate of the housing 110 or disposed at different locations. Each fan 141, 142, 143 corresponds to an air introduction direction, so the heat-generating element that is most affected by each fan may differ according to the air introduction direction.

The power supply part 160 may supply power necessary for the fan 140 to operate. The power supply part 160 receives power from the auxiliary power part 180 and may supply the input power as individual power to each of the plurality of fans 141, 142, 143. As illustrated in FIG. 4, the auxiliary power part 180 can supply driving power to the power supply part 160 or the controller 170, and the power supply part 160 can convert and supply individual power to the fans 141, 142, 143. The individual power supplied to the plurality of fans 141, 142, 143 can be individually controlled. The auxiliary power part 180 can generate and supply auxiliary power using power input to the power conversion device 100. The auxiliary power part 180 may include a flyback converter, or the like.

The controller 170 can PWM control the operation of the fan 140. The controller 170 may include one or more processors and memory, and the processor may execute PWM control commands stored in the memory. The power supply part 160 supplies power to the fan 140, and the controller 170 can control the on/off operation of the fan 140 by applying a PWM signal to the fan 140. PWM (Pulse Width Modulation) control is a control method that variably controls the duty time, which is the time the fan is turned on and by increasing or decreasing the duty time, which is the time the fan is turned on in one cycle, the speed, time, torque, power, or the like, of the fan 140 can be adjusted.

The controller 170 can PWM control a plurality of fans 141, 142, 143 individually. By performing PWM control individually for the plurality of fans 141, 142, 143 according to the environment or conditions, efficient control may be possible.

Here, the controller 170 can perform PWM control for the fans 141, 142, 143 using the temperature inside the housing 110. To this end, the power conversion device 100 according to an embodiment of the present disclosure may include a temperature measuring element 150.

The temperature measuring element 150 may include a plurality of temperature measuring elements. The plurality of temperature measuring elements 151, 152, 153 may each measure the temperature of a plurality of temperature measuring points 130 inside the housing 110 corresponding to the mounting positions of the plurality of fans 141, 142, 143. The paths or locations where the introduction air flows inside the housing 110 may differ for each of the plurality of fans 141, 142, 143, and the temperature measuring positions corresponding to the positions of each plurality of fans 141, 142, 143 may be designated as temperature measuring points 131, 132, 133, and the temperature measuring elements 151, 152, 153 may be disposed at the corresponding locations to measure the temperature. The temperature measurement points 131, 132, 133 may be heat generation elements disposed at the corresponding locations, and the temperature measurement elements 151, 152, 153 may measure the temperature of the corresponding heat generation elements. A plurality of temperature measurement points 131, 132, 133 may be spaced apart from each other. The plurality of temperature measurement points 131, 132, 133 may be spaced apart at equal intervals from each other, or the spacing between them may be close in regions where a lot of heat is generated inside the housing 110 and far apart in regions where less heat is generated. Alternatively, the plurality of temperature measurement points 131, 132, 133 may be disposed at each heat generation element that generates the most heat. Each of the plurality of temperature measurement points 131, 132, 133 may have a corresponding fan 141, 142, 143 set. At this time, it may be set to correspond to a temperature measurement point 131, 132, 133 disposed on the path of the airflow formed by the fan 141, 142, 143, or to correspond to a temperature measurement point 131, 132, 133 disposed adjacent to the fan 141, 142, 143.

The temperature measuring element 150 may include a temperature sensor and a thermistor, and may include an NTC (Negative Temperature Coefficient of Resistance) or a PTC (Positive Temperature Coefficient of Resistance). An NTC is a resistor whose resistance value decreases as the temperature rises, while a PTC is a resistor whose resistance value increases as the temperature rises. The temperature measuring element 150 can measure the temperature of a temperature measuring point 130 using an NTC. The temperature measuring element 150 can measure the temperature of the temperature measuring point 130 at regular intervals. The controller 170 can set the measurement cycle differently according to the temperature of the temperature measuring point 130 or the temperature difference with other temperature measuring points.

The controller 170 can individually control the plurality of fans 141, 142, 143 using the temperature of each of the plurality of temperature measurement points 131, 132, 133 measured by the plurality of temperature measuring elements 151, 152, 153 and the difference between each temperature.

The plurality of temperature measuring elements 151, 152, 153 each measure the temperature of the plurality of temperature measurement points 131, 132, 133 corresponding to the plurality of fans 141, 142, 143, and the controller 170 can control the plurality of fans 141, 142, 143 by comparing the measured temperatures of the plurality of temperature measurement points 131, 132, 133 and using the temperature of the plurality of temperature measurement points 131, 132, 133 and the difference between the temperatures.

The controller 170 may apply a PWM signal having the same duty cycle to the plurality of fans 141, 142, 143 when the difference between each temperature of the plurality of temperature measurement points 131, 132, 133 is less than or equal to a first value. When the difference between each temperature of the plurality of temperature measurement points 131, 132, 133 is less than or equal to a preset first value, heat generation occurs evenly between the temperature measurement points 131, 132, 133 spaced apart throughout the housing 110, so in order to lower the temperature of the entire housing 110, a PWM signal having the same duty cycle may be applied to all of the plurality of fans 141, 142, 143. The duty cycle of the PWM signal applied to the temperature measurement points 131, 132, 133 may be set according to the currently measured temperature. A PWM signal with a larger duty cycle may be applied as the current temperature increases.

The controller 170 may apply a PWM signal with a higher duty cycle than other fans to the fan corresponding to the temperature measurement point with the highest temperature among the plurality of temperature measurement points 131, 132, 133 when the difference between each temperature of the plurality of temperature measurement points 131, 132, 133 is greater than a first value. When the temperature difference between the plurality of temperature measurement points 131, 132, 133 is greater than a first value, it means that a large amount of heat is being generated at a specific location; therefore, in order to quickly lower the temperature at that location, a PWM signal with a higher duty cycle than other fans may be applied to the fan corresponding to the temperature measurement point with the highest temperature among the plurality of temperature measurement points 131, 132, 133. The duty cycle of the PWM signal applied to the temperature measurement points 131, 132, 133 may be set according to the currently measured temperature. A PWM signal with a higher duty cycle may be applied as the current temperature increases.

At this time, the controller 170 can apply a PWM signal having a maximum duty cycle to the fan corresponding to the temperature measurement point with the highest temperature among the plurality of temperature measurement points 131, 132, 133. When the temperature of a specific temperature measurement point is higher than the temperature of another temperature measurement point by a first value or more, the controller 170 can apply a PWM signal having a maximum duty cycle to the fan corresponding to the temperature measurement point to rapidly lower the temperature of the temperature measurement point. When the controller 170 applies a PWM signal with a duty cycle different from that of the other fans to at least one of the plurality of fans 141, 142, 143, the measurement cycle of the temperature measurement element 151, 152, 153 can be set to a short value. Subsequently, when the temperature difference between the plurality of temperature measurement points 131, 132, 133 becomes less than or equal to the first value, the same PWM signal can be applied to the plurality of fans 141, 142, 143, and the measurement cycle can be reset to the previous measurement cycle.

The controller 170 can apply different PWM signals according to the temperature of each temperature measurement point 131, 132, 133 when the difference between each temperature of a plurality of temperature measurement points 131, 132, 133 is greater than a first value. Different PWM signals can be applied by setting a duty cycle according to the ratio of temperatures.

The fault detection part 144 can detect faults in a plurality of fans 141. The fault detection part 144 can detect whether the fan 140 is operating normally by detecting the position information of the blades mounted on the fan 141, and can detect whether there is a fault by detecting the voltage or current of the fan 141. The controller 170 can control the fan 141 according to the signal from the fault detection part 144. The fault detection part 144 can transmit a DC fan fault detect signal to the controller 170.

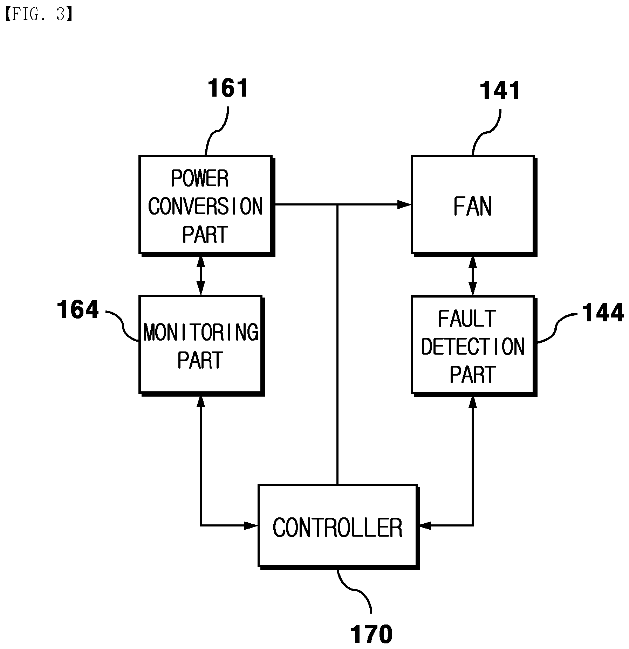

The controller 170 can stop the operation of a fan among a plurality of fans 141, 142, 143 that has received a fault signal from the fault detection part 144. As illustrated in FIG. 3, if the controller 170 detects a fault in a specific fan among a plurality of fans 141, 142, 143 through a signal from the fault detection part 144, the controller 170 can stop the operation of the fan. The controller 170 can apply a PWM signal with a duty cycle of 0 to the fan or control the power supply part 160 so that power is not supplied to the fan. The controller 170 can operate a fan among a plurality of fans 141, 142, 143 that has not received a fault signal from the fault detection part 144 according to the temperature measured by a plurality of temperature measuring elements 151, 152, 153. For fans other than the one detected by the fault detection part 144 as faulty, operation can be performed according to the temperature measured by the temperature measuring elements 151, 152, 153.

The controller 170 can increase the duty cycle of the PWM signal for the fan adjacent to the fan whose operation has stopped according to the fault signal of the fault detection part 144. Through this, it is possible to prevent the temperature from rising at a location where the temperature may rise due to the stopping operation.

The power supply part 160 may include a plurality of power conversion parts 161, 162, 163 that are each connected to a plurality of fans 141, 142, 143 to supply individual power. To supply individual power to each of the plurality of fans 141, 142, 143, a plurality of power conversion parts 161, 162, 163 may be included. The power conversion part 161, 162, 163 may include a buck converter, a boost converter, a buck-boost converter, or the like.

In order to determine whether a plurality of power conversion parts 161, 162, 163 are operating normally, a monitoring part 164 that monitors information of the power conversion parts 161, 162, 163 may be included. As illustrated in FIG. 3, the voltage, current, or the like of the individual power supplied to each fan 141, 142, 143 from each power conversion part 161, 162, 163 can be monitored, and the monitoring information can be supplied to the controller 170. The controller 170 determines whether the power conversion parts 161, 162, 163 are operating normally based on the monitoring information, and if they are operating normally, it can operate the power conversion parts 161, 162, 163 to supply power to each fan 141, 142, 143. At this time, the controller 170 can apply an enable signal to the power conversion part 161, 162, 163.

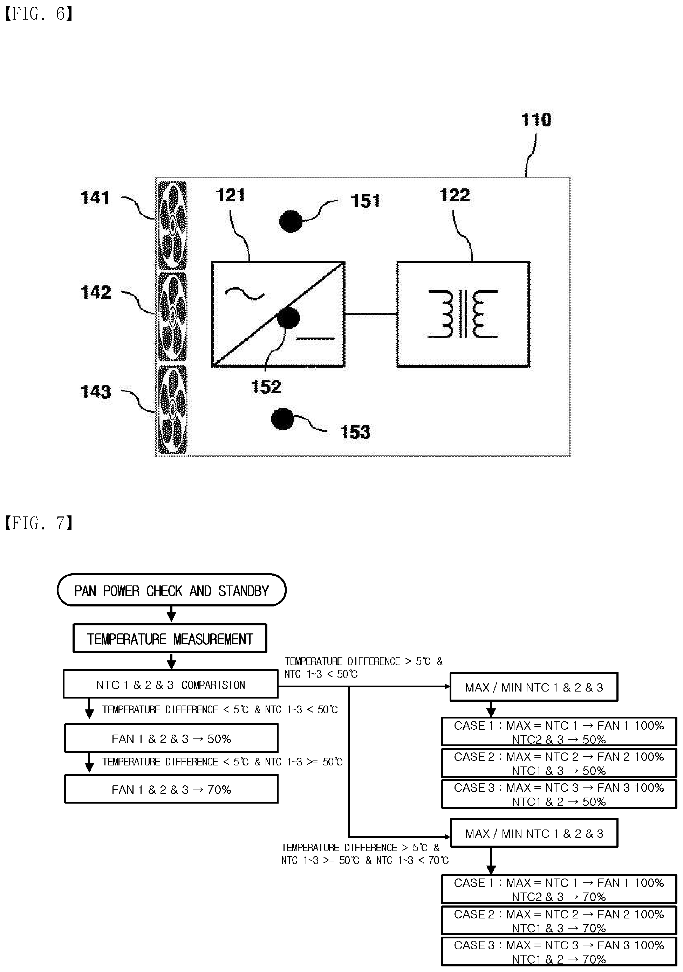

The controller 170 may be an MCU as illustrated in FIG. 5, and the fan buck IC, which is the power supply part 160, can convert the output of the auxiliary power part 180 into individual power, which is a fan DC power, and supply it to a plurality of fans 141, 142, 143, which are DC fans. The plurality of fans 141, 142, 143 may be formed on one side of the housing 110 as illustrated in FIG. 6. The housing 110 may include an AC-DC rectifier 121 and an isolated DC-DC converter 122 which are power conversion elements 120, and a plurality of temperature measurement points 131, 132, 133 used to measure the temperature for controlling the fans 141, 142, 143 may be disposed to correspond to the location of each fan 141, 142, 143.

The controller 170 may receive a monitoring signal 165 from a fan buck IC which is a power supply part 160 and transmit an enable signal 173. By configuring a circuit that supplies individual power to a plurality of fans 141, 142, 143, if a failure such as a power line failure occurs in at least one of the plurality of fans 141, 142, 143, the controller 170 may not apply an enable signal to the power line for that fan, thereby cutting off the power to that fan only. In this way, when an individual failure occurs or is diagnosed, the corresponding fan can be shut off individually, allowing maximum operation with only the other two fans, thereby enabling performance up to the protection temperature of the components.

The controller 170 can supply PWM signals 171, 172 to each fan 141, 142, 143. Additionally, the controller 170 can receive a fault signal from a DC fan fault detector, which is the fault detection part 144, and control the fan accordingly. If the fan does not operate despite the application of a PWM signal, a fault signal is generated and transmitted to the controller 170 to check whether the fan is faulty. In addition to the fault diagnosis signal, a monitoring part 164 for the power supply part 160 is configured so that the controller 170 can perform individual operation and control through fault diagnosis not only of the fan itself but also of the circuit supplying power to each fan.

The controller 170 can control the rotational speed of the fans 141, 142, 143 by controlling the pulse width Duty cycle, % of the signal applied to the fans 141, 142, 143. Since the heat generation points and components of electrical components, such as the power conversion element 120 within the power conversion device 100 which is a power module, may all be different, if the duty cycles of a plurality of fans 141, 142, 143 are controlled equally, the power consumed by the fans increases, which may cause a loss, i.e., a decrease in performance accordingly. For example, if heat generation occurs only at the temperature measurement point 151 of FIG. 6 and heat generation at the temperature measurement point 153 is such that the fan does not need to be driven, then the temperature of the temperature measurement point 151 can be lowered by driving only the fan 141 or the fan 141 and fan 142 corresponding to the temperature measurement point 151.

The process of efficiently controlling the fans 141, 142, 143 in the controller 170 can be performed as illustrated in FIG. 7. First, the power of the fans 141, 142, 143 is checked, and if the power of the fans 141, 142, 143 is normal, after standing by, the temperature measuring element 151, 152, 153 measures the temperature of the temperature measuring point 131, 132, 133. Here, the temperature measuring element 151, 152, 153 may be an NTC, and compare the measured temperatures NTC1, 2, 3. As a result of comparison, if the temperature difference between the temperatures NTC1, 2, 3 is less than the first value of 5 degrees and all temperatures NTC1, 2, 3 are less than 50 degrees, a PWM signal with a duty cycle of 50% can be applied to the fans 141, 142, 143; if all temperatures NTC1, 2, 3 are 50 degrees or higher, a PWM signal with a duty cycle of 70% can be applied to the fans 141, 142, 143.

As a result of comparison, if the temperature difference between the temperatures NTC1, 2, 3 is greater than the first value of 5 degrees and all temperatures NTC1, 2, 3 are less than 50 degrees, a PWM signal with a duty cycle of 100% maximum duty cycle can be applied to the fan corresponding to the temperature measurement point with the highest temperature, and a PWM signal with a duty cycle of 50% can be applied to the other fans.

When the temperature difference between the temperatures NTC1, 2, 3 is greater than the first value of 5 degrees and the temperatures NTC1, 2, 3 are all between 50 degrees or more and less than 70 degrees, a PWM signal with a duty cycle of 100%, which is the maximum duty cycle, can be applied to the fan corresponding to the temperature measurement point with the highest temperature, and a PWM signal with a duty cycle of 70% can be applied to the other fans.

As described above, the performance of the power module can be improved by implementing an individual power supply circuit and a fault diagnosis circuit for a cooling PWM DC FAN applied to an EV charger module, that is, a power conversion device 100 which is an electric vehicle charging device, and by individually controlling the fan according to temperature.

Those skilled in the art related to the present embodiment will understand that it may be implemented in a modified form without departing from the essential characteristics of the above description. Therefore, the disclosed methods should be considered in an illustrative rather than a limiting sense. The scope of the present disclosure is defined by the claims, not by the foregoing description, and all variations within the equivalent scope should be interpreted as being included in the present disclosure.

## Claims

1. A power conversion device comprising:
a housing accommodating a plurality of elements that perform power conversion;
a plurality of fans mounted in the housing;
a plurality of temperature measuring elements configured to respectively measure temperatures of a plurality of temperature measuring points inside the housing corresponding to mounting positions of the plurality of fans, respectively;
a power supply unit configured to supply individual power to the plurality of fans; and
a controller configured to perform PWM control of the plurality of fans.

2. The power conversion device of claim 1,
wherein the controller individually controls the plurality of fans using the temperature of each of the plurality of temperature measurement points measured by the plurality of temperature measuring elements and a difference between each temperature.

3. The power conversion device of claim 2,
wherein the controller applies a PWM signal having same duty cycle to the plurality of fans when the difference between each temperature of the plurality of temperature measurement points is a first value or less.

4. The power conversion device of claim 2,
wherein the controller, when the difference between each temperature of the plurality of temperature measurement points is greater than a first value, applies a PWM signal having a higher duty cycle than other fans to a fan corresponding to a temperature measurement point with the highest temperature of the plurality of temperature measurement points.

5. The power conversion device of claim 3,
wherein the controller applies a PWM signal having a maximum duty cycle to a fan corresponding to the temperature measurement point with the highest temperature of the plurality of temperature measurement points.

6. The power conversion device of claim 1, comprising:
a fault detection unit configured to detect a fault in the plurality of fans,
wherein the controller controls the plurality of fans according to a signal from the fault detection unit.

7. The power conversion device of claim 6,
wherein the controller stops operation of a fan of the plurality of fans that has received a fault signal from the fault detection unit, and operates a fan of the plurality of fans that has not received a fault signal from the fault detection unit according to the temperatures measured by the plurality of temperature measuring devices.

8. The power conversion device of claim 1,
wherein the power supply unit comprises a plurality of power conversion units each connected to the plurality of fans to supply the individual power, and
wherein the power conversion device comprises a monitoring unit configured to monitor information of the plurality of power conversion units.

9. The power conversion device of claim 1, comprising:
an auxiliary power supply unit configured to supply power to the controller,
wherein the power supply unit converts power applied from the auxiliary power supply unit and supplies the power to each of the plurality of fans.

10. The power conversion device of claim 1,
wherein the plurality of temperature measuring elements comprise an NTC element or a PTC element.
